(19) **Europäisches Patentamt**

**European Patent Office**

**Office européen des brevets**

(11) **EP 1 079 514 A1**

(12) **DEMANDE DE BREVET EUROPEEN**

| | |
|---|---|
| (43) Date de publication:<br>**28.02.2001 Bulletin 2001/09** | (51) Int Cl.[7]: **H03C 3/09** |

(21) Numéro de dépôt: **00402323.0**

(22) Date de dépôt: **21.08.2000**

| | |
|---|---|
| (84) Etats contractants désignés:<br>**AT BE CH CY DE DK ES FI FR GB GR IE IT LI LU MC NL PT SE**<br>Etats d'extension désignés:<br>**AL LT LV MK RO SI** | (72) Inventeurs:<br>• **Savelli, Patrick**<br>  **75012 Paris (FR)**<br>• **Massy, Christian**<br>  **92310 Sevres (FR)** |
| (30) Priorité: **26.08.1999 FR 9910798** | (74) Mandataire: **Lamoureux, Bernard et al**<br>**COMPAGNIE FINANCIERE ALCATEL**<br>**Dépt. Propriété industrielle**<br>**30, avenue Kléber**<br>**75116 Paris (FR)** |
| (71) Demandeur: **ALCATEL**<br>**75008 Paris (FR)** | |

(54) **Synthétiseur de fréquence à boucle de phase**

(57) L'invention concerne un synthétiseur de fréquences à boucle de phase comportant des moyens (13) de détermination du gain réel de l'oscillateur commandé en tension (1) à partir d'au moins un paramètre de mesure, ces moyens (13) de détermination étant aptes à délivrer un signal représentatif du gain réel de l'oscillateur commandé en tension (1). Des moyens (30,32,34,38,40,42) sont prévus pour introduire un signal de modulation entre le comparateur de phase (7) de la boucle de phase et l'oscillateur (1) commandé en tension de ladite boucle de phase. Par ailleurs des moyens (50) de compensation de modulation sont prévus pour préparer à partir du signal de modulation un signal de compensation et pour introduire celui-ci dans la boucle de retour (9) en amont d'un compteur diviseur (8) disposé dans celle-ci, de manière à annuler la modulation du signal de l'oscillateur commandé en tension.

FIG_2

**Description**

La présente invention a pour objet un synthétiseur de fréquence, dit aussi circuit d'oscillation asservi, utilisable en particulier dans des émetteurs et récepteurs radiofréquences. A ce titre il est plus particulièrement utilisable dans le domaine des radiotéléphones pour lequel notamment la rapidité d'accrochage d'une porteuse est essentielle. Un des buts de l'invention est ainsi de fournir un moyen permettant un accrochage efficace.

Dans le domaine de la téléphonie mobile, notamment de type GSM TDMA (Global System for Mobile, Système de téléphonie mobile global, Time Division Multiple Access, accès multiple à répartition dans le temps), des canaux de communication sont institués pour relier des téléphones mobiles à des stations de base. Un canal est défini par une fenêtre temporelle choisie parmi plusieurs fenêtres d'une même trame. Dans une application la plus connue une trame possède huit fenêtres. Comme autre caractéristique, un canal est associé à une fréquence de porteuse. Un ensemble de bandes de modulation est ainsi réparti dans une gamme, en émission ou en réception. Pour fixer les idées une bande a dans la norme GSM une largeur de fréquence de 200 KHz, et il y a plus d'une centaine de fréquences de porteuse différentes dans une gamme.

Du fait des déficits de propagation survenant, pour certaines fréquences entre certains lieux d'un territoire, il a été admis que pour un canal donné une loi de fréquence impose à la fréquence porteuse (à la bande passante utilisée) de changer périodiquement. Dans la pratique le changement a lieu à chaque trame. Ainsi la liaison entre un téléphone mobile et une station de base connaît une fréquence porteuse qui change régulièrement. Ceci impose que dans un émetteur récepteur, un synthétiseur de fréquences puisse sauter régulièrement, et rapidement, d'une fréquence de porteuse à une autre.

Une fenêtre temporelle a une durée normalisée, dans la norme GSM, de 577 microsecondes. Une trame de huit fenêtres dure ainsi 4,615 millisecondes. Pour assurer à la fois l'émission et la réception, il est prévu que, dans une même trame, une fenêtre sera utilisée pour l'émission alors qu'une autre fenêtre sera utilisée pour la réception. Normalement, l'écart temporel qui sépare la fenêtre temporelle d'émission de la fenêtre temporelle de réception est au moins égal à la durée d'une fenêtre temporelle et demie. Ceci signifie qu'un émetteur récepteur de téléphonie mobile, notamment dans un téléphone mobile jouit d'une durée de l'ordre de 865 microsecondes pour accrocher la fréquence de porteuse qui lui est allouée pour assurer entre autres le caractère duplex de la communication.

Néanmoins, pour les systèmes de diffusion de type GPRS/HSCSD (qui signifie General Packet Radio Service/High Speed Circuit Switch Data, dont le sens est service général de transmission de paquets d'informations radioélectriques, commutateur de circuit de données à haute vitesse), il est prévu qu'un téléphone mobile et ou la station de base, pour des questions d'augmentation du débit d'informations, puisse émettre et ou recevoir des signaux radioélectriques pendant des fenêtres temporelles successives d'une même trame. Il est ainsi possible que deux, trois ou quatre fenêtres successives d'une même trame soient dévolues à un sens de communication entre un téléphone mobile et une station de base. Dans ce cas, d'une fenêtre à l'autre la fréquence de porteuse ne change pas.

Cependant une telle pratique a conduit à modifier la norme utilisable. En effet du fait de ces utilisations consécutives, le nombre de fenêtres restant disponibles dans une même trame est réduit, de sorte qu'il n'est plus possible d'assurer une séparation temporelle d'au moins une fenêtre et demie entre les deux sens de communication. Dans ces conditions, la norme prévoit qu'une seule fenêtre temporelle sera neutralisée entre émission et réception. Il en résulte que les temps de ralliement des oscillateurs pour accrocher les fréquences de porteuses sont réduits. Autant auparavant, avec une durée disponible de 865 microsecondes, une durée d'accrochage de 500 microsecondes était acceptable, autant maintenant une telle durée n'est plus acceptable si le temps de ralliement est réduit à 577 microsecondes.

Pour accélérer l'accrochage du synthétiseur à une fréquence porteuse, il est connu du document US 4,105,948 de prépositionner en fréquence la boucle de phase PLL du synthétiseur.

A cet effet, la boucle de phase PLL est ouverte pendant un bref délai par l'intermédiaire d'un commutateur entre le filtre de boucle et l'oscillateur commandé en tension VCO, et on alimente cet oscillateur VCO par une tension externe pour forcer celui-ci d'émettre un signal dont la fréquence est proche de la fréquence à atteindre. Ensuite, après un certain délai, la boucle de phase est refermée pour que le synthétiseur s'ajuste automatiquement à la nouvelle fréquence de porteuse.

La tension externe appliquée à l'oscillateur de fréquences pour forcer celui-ci de changer quasiment instantanément de fréquence d'émission est déduite du gain nominatif de l'oscillateur commandé en tension. Le prépositionnement de l'oscillateur commandé en tension de la PLL est d'autant plus efficace que le gain de l'oscillateur VCO est connu avec précision.

Cependant, il a été constaté qu'une fois installé, le gain réel de l'oscillateur commandé en tension peut varier en fonction de différents paramètres comme par exemple la température externe ou le temps de fonctionnement de cet oscillateur. Par conséquent, en fonction des paramètres externes de fonctionnement, le gain nominatif de l'oscillateur VCO peut être sensiblement différent du gain réel de celui-ci, ce qui conduit à une perte d'efficacité du prépositionnement et donc à un allongement du temps d'accrochage du synthétiseur à la nouvelle fréquence porteuse.

On comprend donc qu'il est important de maîtriser une variation du gain de l'oscillateur VCO afin de réduire au maximum le temps de ralliement du synthétiseur.

Un autre problème connexe des synthétiseurs connus de fréquences à boucle de phase est le traitement du bruit dans la boucle.

Les synthétiseurs de l'état de la technique comportent d'une manière classique un oscillateur commandé en tension dont la commande résulte de la comparaison de la phase d'un signal produit par l'oscillateur avec la phase d'un signal de référence représentatif de la fréquence d'oscillation à produire. La réalisation d'un tel asservissement nécessite alors la réalisation dans la boucle d'asservissement d'un filtre passe bas dont la bande passante est limitée par la fréquence de comparaison du comparateur de phase.

Le principe d'un comparateur de phase consiste à comparer des signaux et à produire à sa sortie un signal d'erreur. On commande l'oscillateur avec ce signal d'erreur. Ce signal d'erreur est admis dans un filtre passe bas pour le lisser. La fréquence de coupure de ce filtre passe bas est sensiblement du dixième de la fréquence de comparaison. Aux fréquences envisagées, avec une fréquence de comparaison de 200 KHz, ceci amène un tel filtre à comporter une constante de temps de l'ordre de 50 microsecondes. Pour un accrochage moyen, on obtient alors une durée, irréductible, du temps de ralliement de l'ordre de 500 microsecondes.

Lorsqu'un tel synthétiseur est utilisé en transmission, la fréquence de référence est modulée à l'entrée du comparateur de phase. Or, un tel montage nécessite une largeur de bande de la boucle, et donc du filtre de boucle disposé entre le comparateur de phase et l'oscillateur commandé en fréquence, qui soit plus large.

Par conséquent, le bruit dans la largeur de bande de boucle se trouve augmenté et il est difficile de respecter le spectre recommandé notamment par la norme GSM.

Un but de l'invention est donc de proposer un synthétiseur de fréquence à boucle de phase présentant de meilleures caractéristiques de bruit que dans l'art antérieur. Un autre but de l'invention est de proposer un synthétiseur de fréquence à boucle de phase dont les variations de gain de l'oscillateur commandé en tension peuvent être maîtrisées.

Encore un autre but de l'invention consiste à proposer un synthétiseur de fréquence à boucle de phase ayant un temps de ralliement court. A cet effet, l'invention a pour objet un synthétiseur de fréquences comprenant une boucle de régulation de phase comprenant un oscillateur commandé en tension, un oscillateur de référence , une boucle d'asservissement de phase recevant en entrées, le signal de l'oscillateur commandé en tension et celui de l'oscillateur de référence, délivrant en sortie la commande en tension de l'oscillateur commandé en tension et comprenant un comparateur de phase connecté d'une part directement à une sortie de l'oscillateur de référence et d'autre part à une sortie de l'oscillateur commandé en tension par l'intermédiaire d'une boucle de retour dans laquelle est disposé un compteur diviseur, des moyens pour introduire un signal de modulation entre le comparateur de phase et l'oscillateur commandé en tension, caractérisé en ce qu'il comporte en outre des moyens de compensation de modulation pour préparer à partir du signal de modulation un signal de compensation pour introduire ce signal de compensation dans la boucle de retour en amont du compteur diviseur de manière à annuler la modulation du signal en sortie de l'oscillateur commandé en tension et destiné à l'entrée du compteur.

Selon un mode de réalisation, le synthétiseur selon l'invention comporte des moyens de détermination du gain réel de l'oscillateur commandé en tension à partir d'au moins un paramètre de mesure, ces moyens de détermination étant aptes à délivrer un signal représentatif du gain réel de l'oscillateur commandé en tension.

Selon un mode de réalisation, le synthétiseur selon l'invention comprend en outre des moyens diviseur ayant une première entrée destinée à recevoir desdits moyens de détermination le signal représentatif du gain réel de l'oscillateur commandé en tension, une seconde entrée destinée à recevoir le signal de modulation, et une sortie délivrant le signal de modulation divisé par le gain réel de l'oscillateur commandé en tension et connectée à une entrée d'un circuit de sommation disposé entre un filtre de boucle et l'oscillateur commandé en tension , le filtre de boucle étant disposé entre la sortie du comparateur de phase et l'entrée de l'oscillateur commandé en tension.

Le synthétiseur selon l'invention peut encore comporter une ou plusieurs des caractéristiques suivantes :

- le synthétiseur comprend de plus un filtre de boucle disposé entre la sortie du comparateur de phase et l'entrée de l'oscillateur commandé en tension et lesdits moyens de détermination comprennent des moyens de mesure pour mesurer la tension en sortie du filtre de boucle à une première fréquence et à une seconde fréquence, et une unité de calcul du gain réel de l'oscillateur commandé en tension en divisant la différence de fréquence entre la première et la seconde fréquences par la différence des première et seconde tensions de commande, mesurées respectivement à la première et la seconde fréquences,

- lesdits moyens de détermination comprennent en outre un convertisseur analogique-numérique adapté pour convertir une tension mesurée par les moyens de mesure en un signal numérique et ladite unité de calcul est une unité numérique,

- lesdits moyens de détermination comprennent un capteur de température et une mémoire d'une table du gain de l'oscillateur commandé en tension en fonction de la température et une unité de commande pour délivrer le gain réel de l'oscillateur commandé en tension en fonction de la température mesurée et des valeurs de gain stockées dans la mémoire,

- lesdits moyens de détermination comprennent un moyen de mesure du temps de fonctionnement de l'oscillateur commandé en tension et une mémoire d'une table du gain de l'oscillateur commandé en tension en fonction de son temps de fonctionnement, et une unité de commande pour délivrer le gain réel de l'oscillateur commandé en tension en fonction du temps de fonctionnement délivré du compteur et des valeurs de gain stockées dans la mémoire,

- les moyens de compensation comprennent un multiplicateur du signal de modulation par $2\pi$, un accumulateur dont l'entrée est connectée à la sortie du multiplicateur, une unité pour former d'une part un signal en phase I et d'autre part sa quadrature Q, un premier mélangeur et un second mélangeur disposés chacun dans une branche de la boucle de retour en amont du compteur diviseur, le premier mélangeur étant adapté pour mélanger le signal en phase I avec le signal en sortie de l'oscillateur commandé en tension et le second mélangeur étant adapté pour mélanger le signal en quadrature Q avec le signal en sortie de l'oscillateur commandé en tension déphasé de $\pi/2$.

D'autres caractéristiques et avantages de l'invention ressortiront de la description suivante, donnée à titre d'exemple, sans caractère limitatif, en regard des dessins annexés :

- La figure 1 est un schéma synoptique du synthétiseur de fréquences selon l'invention
- La figure 2 est un schéma synoptique d'un développement du synthétiseur de fréquences selon l'invention.

Le synthétiseur selon l'invention est, de préférence, monté dans un téléphone mobile, en particulier un téléphone mobile fonctionnant selon une ou plusieurs des normes suivantes : GSM, DCS, PCS ou UMTS.

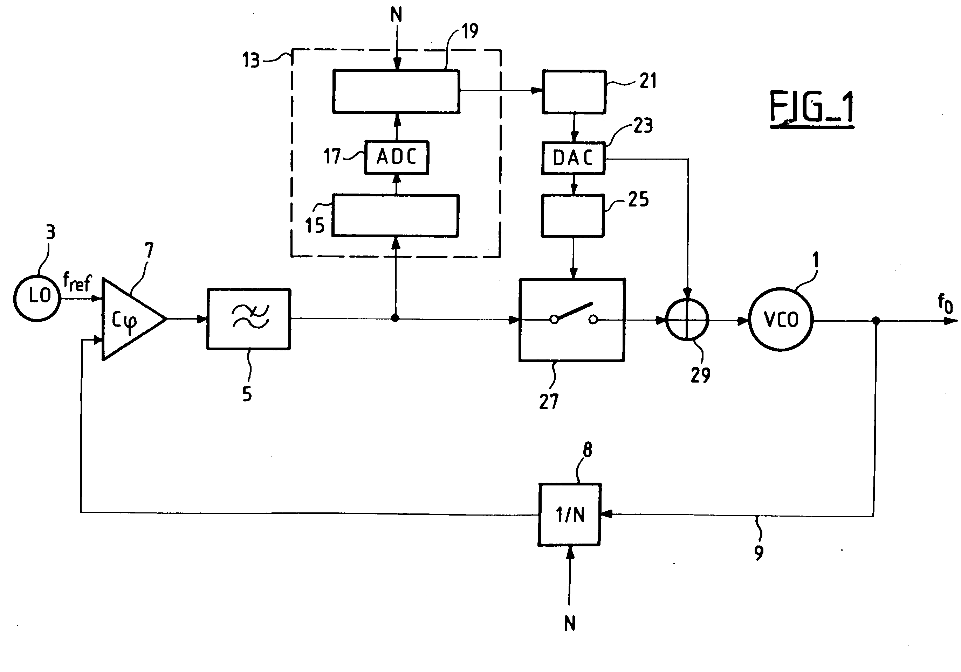

Comme le montre la figure 1, le synthétiseur de fréquences à boucle de phase comprend un oscillateur commandé en tension VCO 1 asservie sur un oscillateur de référence 3 au moyen d'un boucle d'asservissement de phase. La boucle d'asservissement de phase comporte principalement un filtre de boucle 5, un comparateur de phase - fréquence 7 et un compteur diviseur 8.

Le filtre de boucle 5 est connecté entre l'entrée de commande en tension de l'oscillateur VCO 1 et la sortie du comparateur de phase - fréquence 7.

Le comparateur de phase - fréquence 7 possède deux entrées, une première connectée directement à la sortie de l'oscillateur de référence 3 et une seconde connectée à la sortie de l'oscillateur VCO 1 par l'intermédiaire d'une boucle de retour 9 dans laquelle est disposé le compteur diviseur 8.

Le compteur diviseur 8 comprend une entrée pour recevoir une commande de son rang N de division.

En outre, le synthétiseur comprend des moyens 13 de détermination du gain réel de l'oscillateur commandé en tension VCO 1.

Ces moyens 13 comportent un capteur de mesure 15 pour mesurer, en sortie du filtre à boucle 5, une première tension de commande $V_1$ à une première fréquence $f_1$ et une seconde tension de commande $V_2$ à une seconde fréquence $f_2$. De préférence, ces fréquences $f_1$ et $f_2$ sont des fréquences porteuses définies dans la ou les normes selon laquelle/lesquelles un téléphone portable comprenant le synthétiseur selon l'invention fonctionne, à savoir les normes GSM, DCS, PCS ou UMTS. Pour ses mesures, le capteur 15 profite de préférence des changements périodiques des fréquences porteuses imposés par ces normes.

La sortie du capteur 15 est connectée à l'entrée d'un convertisseur 17 analogique - numérique qui convertit les tensions mesurées en signaux numériques.

La sortie du convertisseur 17 est connectée à l'entrée d'une unité de calcul 19 qui divise la différence entre la seconde et la première fréquences par la différence entre les seconde et première tensions mesurées.

En effet, le gain réel $K_{VCO}$ de l'oscillateur commandé en tension VCO 1 est donné par la relation :

$$K_{VCO} = \frac{f_2 - f_1}{V_2 - V_1}.$$

Pour calculer les fréquences $f_1$ et $f_2$, l'unité 19 reçoit sur une entrée le rang N de division appliqué au compteur diviseur 8. Etant donné que la fréquence de sortie d'un synthétiseur à boucle de phase est toujours donnée par la relation suivante :

$$f_0 = N \times f_{ref},$$

et que $f_{ref}$ est connue avec précision, l'unité 19 calcule le gain réel $K_{VCO}$ à partir de la formule suivante :

$$K_{VCO} = \frac{N_2 - N_1}{V_2 - V_1} f_{ref},$$

où $N_1$ et $N_2$ sont les rangs de division du compteur diviseur 8 aux fréquences respectives $f_1$ et $f_2$.

Avantageusement, le gain réel de l'oscillateur commandé en tension VCO 1 est déterminé seulement à chaque initialisation du terminal mobile dans lequel le synthétiseur selon l'invention est implanté.

Bien entendu, une mise à jour plus fréquente du gain peut être envisagée, en particulier si le terminal mobile se déplace par exemple dans un environnement présentant des fluctuations de température importantes comme cela se présente par exemple en hiver avec les différences de température entre l'intérieur et l'extérieur.

Selon une variante non représentée du synthétiseur selon l'invention, qui est particulièrement adaptée à des synthétiseurs évoluant dans un environnement à fortes fluctuations de température, lesdits moyens de détermination du gain réel comprennent un capteur de température, une mémoire contenant une table du gain de l'oscillateur commandé en tension en fonction de la température ainsi qu'une unité de commande apte à délivrer le gain réel de l'oscillateur VCO 1 en fonction de la température mesurée et des valeurs de gain stockées dans la table de la mémoire.

Selon une autre variante avantageuse non représentée du synthétiseur selon l'invention, les moyens de détermination 13 comprennent un moyen de mesure du temps de fonctionnement de l'oscillateur VCO 1, tel qu'un compteur du temps de fonctionnement, et une mémoire contenant une table du gain de l'oscillateur VCO 1 en fonction de son temps de fonctionnement et une unité de commande apte à délivrer le gain réel de l'oscillateur VCO 1 en fonction du temps de fonctionnement reçu du compteur et des valeurs de gain stockées dans la table de la mémoire.

Par ailleurs, une sortie de l'unité de calcul 19 est raccordée à une entrée correspondante d'une unité de commande 21 d'une tension de prépositionnement appliquée à l'oscillateur VCO 1.

Etant donné que cette unité de commande 21 est de préférence une unité tout numérique, sa sortie est raccordée à une entrée d'un convertisseur numérique-analogique 23.

La sortie du convertisseur 23 est raccordée d'une part à un circuit de temporisation 25 qui commande un commutateur 27 disposé dans la boucle de phase en aval du filtre de boucle 5, et d'autre part à un circuit de sommation 29 disposé dans la boucle de phase entre le commutateur 27 et l'oscillateur VCO 1 pour pouvoir appliquer la tension de prépositionnement à l'oscillateur VCO 1.

En fonctionnement, l'oscillateur commandé en tension VCO 1 délivre un signal de sortie à la fréquence $f_0$ du synthétiseur de fréquences. L'oscillateur de référence 3 délivre un signal de référence à la fréquence $f_{ref}$. Le compteur diviseur 8 divise, dans le présent exemple dans un rapport entier N, la fréquence $f_0$ de l'oscillateur VCO 1 avant de soumettre dans le comparateur phase- fréquence 7 de sorte que la boucle de phase assure l'égalité :

$$f_0 = N \times f_{ref}$$

Au moins lors de la phase d'initialisation, les moyens 13 déterminent en fonction d'un paramètre de mesure tel que la tension en aval du filtre de boucle 5, de la température de fonctionnement ou du temps de fonctionnement, le gain réel de l'oscillateur VCO 1 pour permettre un prépositionnement optimisé de la boucle de phase lors d'un changement de fréquence de sortie du synthétiseur.

Ce gain réel est délivré à l'unité de commande 21. Lors d'un changement de la fréquence de sortie de la boucle de phase, le commutateur 27 ouvre, commandé par le circuit de temporisation 25, la boucle de phase pendant un délai prédéterminé, lors duquel on applique une tension de prépositionnement via le circuit de sommation 27 à l'oscillateur VCO 1. Cette tension de prépositionnement est déterminée par l'unité 21 en fonction du gain réel de l'oscillateur VCO 1.

Ainsi, grâce à la connaissance du gain réel de l'oscillateur VCO 1, la tension de prépositionnement permet d'obtenir une fréquence de sortie très proche de la fréquence de sortie souhaitée et, une fois le commutateur 27 à nouveau en position de fermeture, la boucle de phase se verrouille plus rapidement.

On comprend donc que la maîtrise du gain réel de l'oscillateur VCO 1 permet de raccourcir le temps de ralliement de la boucle de phase PLL, ceci pour tout environnement de fonctionnement, car le synthétiseur selon l'invention est mois sensible aux fluctuations du gain dues à des influences externes ou internes comme par exemple des variations de température ou le vieillissement.

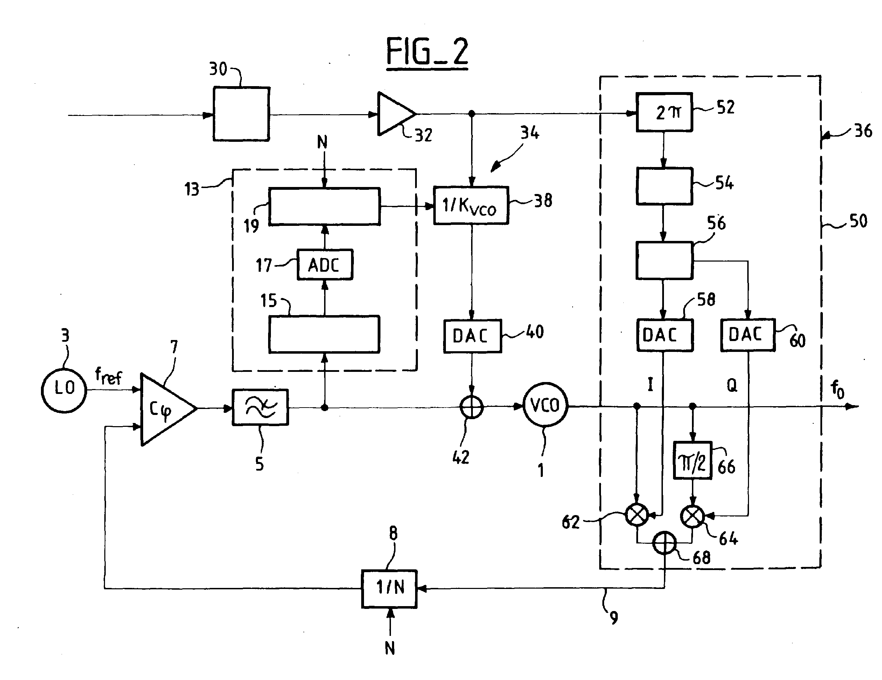

On se réfère maintenant à la figure 2 qui présente un schéma synoptique d'un développement selon l'invention. Sur cette figure, les éléments identiques à ceux de la figure 1 portent les mêmes numéros de référence.

Le développement du synthétiseur de la figure 2 par rapport à celui de la figure 1 réside en particulier dans le fait qu'il s'agit d'un synthétiseur modulé et sans prépositionnement.

A cet effet, le synthétiseur selon l'invention comprend un filtre gaussien 30 recevant à son entrée des signaux numériques représentatifs des données à transmettre, et un amplificateur 32 pour amplifier les signaux filtrés en sortie du filtre 30.

La sortie de l'amplificateur 32 est raccordée d'une part à une branche 34 de modulation et d'autre part à une banche 36 de compensation.

La branche 34 de modulation comprend un diviseur 38 présentant une première entrée recevant les signaux filtrés et amplifiés en sortie de l'amplificateur 32 et une seconde entrée recevant un signal en sortie de l'unité de calcul 19, représentatif du gain déterminé $K_{VCO}$ réel de l'oscillateur 1 commandé en tension.

Le diviseur 38 est adapté pour diviser le signal de modulation filtré et amplifié par le gain réel déterminé de l'oscillateur VCO commandé en tension 1. La sortie du diviseur 38 est raccordée à l'entrée d'un convertisseur numérique - analogique 40 convertissant le signal en sortie du diviseur 38 en un signal analogique.

La sortie du convertisseur 40 est raccordée à une des deux entrées d'un circuit 42 de sommation disposé entre le filtre de boucle 5 et l'oscillateur VCO commandé en tension 1. On comprend donc que l'autre entrée du circuit de sommation 42 est connectée à la sortie du filtre de boucle 5 et que la sortie du circuit 42 est raccordée à l'entrée de l'oscillateur commandé en tension 1. Cette branche 34 sert donc à préparer le signal de modulation et à l'introduire dans la boucle de phase PLL.

Afin de ne pas polluer le signal dans la boucle de retour 9 avec les modulations en sortie de l'oscillateur VCO 1 et pour garantir une bonne stabilité de la fréquence synthétisée, le synthétiseur selon l'invention comprend en outre, disposés dans la branche 36 de compensation, des moyens 50 de compensation pour préparer à partir du signal de modulation un signal de compensation et pour introduire ce signal de compensation dans la boucle de retour 9 en amont du compteur diviseur 8.

Ces moyens 50 de compensation comprennent un multiplicateur 52 par $2\pi$ du signal de modulation en sortie de l'amplificateur 32, un accumulateur 54 dont l'entrée est connectée à la sortie du multiplicateur 52, une unité 56 pour former par des transformations connus de type cosinus et sinus respectivement d'une part un signal en phase I et d'autre part sa quadrature Q.

Avantageusement, aussi bien le multiplicateur 52, l'accumulateur 54 ainsi que l'unité 56 sont des composants numériques.

Le signal numérique en phase I ainsi que le signal numérique en quadrature Q en sortie de l'unité 56 sont convertis en des signaux analogiques par des convertisseurs 58 et 60 respectifs.

Puis, le signal analogique en phase I est introduit dans une des deux entrées d'un premier mélangeur 62, l'autre entrée du mélangeur 62 recevant le signal modulé en sortie de l'oscillateur VCO commandé en tension. 1, pour mélanger le signal en phase I avec le signal en sortie de l'oscillateur commandé en tension.

Le signal analogique en quadrature Q est introduit dans une des deux entrées d'un second mélangeur 64, l'autre entrée du mélangeur 64 recevant le signal modulé en sortie d'un déphaseur 66 de $\pi/2$ du signal en sortie de l'oscillateur VCO commandé en tension 1, pour mélanger le signal en quadrature Q avec le signal en sortie de l'oscillateur commandé en tension déphasé de $\pi/2$.

Enfin, les signaux en sortie des mélangeurs 62 et 64 sont appliqués aux entrées correspondantes d'un circuit de sommation 68. La sortie du circuit de sommation est raccordée à l'entrée du compteur diviseur 8.

Le fonctionnement du synthétiseur représenté sur la figure 2 diffère de celui de la figure 1 par le fait que d'une part, il n'y a pas de prépositionnement lors d'un changement de la fréquence de sortie et que d'autre part, un signal de modulation spécifiquement préparé est introduit dans la boucle de phase PLL entre le filtre de boucle 5 et l'oscillateur VCO commandé en tension 1, ce qui permet de disposer d'un synthétiseur ayant un oscillateur de référence 3 stable et non modulé. En sortie de l'oscillateur VCO 1, on obtient donc un signal à la fréquence $f_0$ modulé par le signal de modulation.

Par le fait de diviser le signal de modulation par le gain réel de l'oscillateur VCO 1, on réduit l'erreur de phase de la modulation en sortie de l'oscillateur VCO 1.

En effet, on compense numériquement le gain de l'oscillateur VCO 1. Cette compensation est nécessaire, car la phase du signal modulé serait affecté par le gain, ce qui aurait pour effet de modifier l'indice de modulation.

En outre, afin que le signal introduit dans le compteur diviseur 8 soit un signal non modulé à la fréquence $f_0$, on annule dans la boucle de retour 9 la modulation du signal en sortie de l'oscillateur VCO 1 en préparant des signaux en phase I et en quadrature Q de compensation et en les introduisant dans la boucle de retour 9 .

Du fait que le signal introduit dans le compteur diviseur 8 est un signal non modulé à la fréquence $f_0$, la largeur de bande du filtre de boucle 5 peut être plus étroite, ce qui permet efficacement de diminuer le bruit dans la boucle de phase PLL.

Bien entendu, on peut envisager de combiner les modes de réalisations représentés sur les figures 1 et 2 pour obtenir un synthétiseur modulé avec prépositionnement de fréquence.

## Revendications

1. Synthétiseur de fréquences comprenant une boucle de régulation de phase comprenant un oscillateur commandé en tension (1), un oscillateur de référence (3), , une boucle d'asservissement de phase recevant en entrées, le signal de l'oscillateur commandé en tension (1) et celui de l'oscillateur de référence (3), délivrant en sortie la commande en tension de l'oscillateur commandé en tension (1) et comprenant un comparateur de phase (7) connecté d'une part directement à une sortie de l'oscillateur de référence (3) et d'autre part à une sortie de l'oscillateur commandé en tension (1) par l'intermédiaire d'une boucle de retour (9) dans laquelle est disposé un compteur diviseur (8), des moyens (30, 32, 34, 38, 40, 42) pour introduire un signal de modulation entre le comparateur de phase (7) et l'oscillateur commandé en tension (1), caractérisé en ce qu'il comporte en outre des moyens (50) de compensation de modulation pour préparer à partir du signal de modulation un signal de compensation pour introduire ce signal de compensation dans la boucle de retour (9) en amont du compteur diviseur (8) de manière à annuler la modulation du signal en sortie de l'oscillateur commandé en tension et destiné à l'entrée du compteur.

2. Synthétiseur selon la revendication 1, caractérisé en ce qu'il comporte des moyens (13) de détermination du gain réel de l'oscillateur commandé en tension (1) à partir d'au moins un paramètre de mesure, ces moyens (13) de détermination étant aptes à délivrer un signal représentatif du gain réel de l'oscillateur commandé en tension (1).

3. Synthétiseur selon la revendication 2, caractérisé en ce qu'il comprend en outre des moyens diviseur (38) ayant une première entrée destinée à recevoir desdits moyens (13) de détermination le signal représentatif du gain réel de l'oscillateur commandé en tension (1), une seconde entrée destinée à recevoir le signal de modulation, et une sortie délivrant le signal de modulation divisé par le gain réel de l'oscillateur commandé en tension (1) et connectée à une entrée d'un circuit de sommation (42) disposé entre un filtre de boucle (5) et l'oscillateur commandé en tension (1), le filtre de boucle (5) étant disposé entre la sortie du comparateur de phase (7) et l'entrée de l'oscillateur commandé en tension (1).

4. Synthétiseur selon l'une des revendications 1 à 3, caractérisé en ce que lesdits moyens (13) de détermination comprennent des moyens de mesure (15) pour mesurer la tension en sortie du filtre de boucle (5) à une première fréquence et à une seconde fréquence, et une unité de calcul (19) du gain réel de l'oscillateur commandé en tension (1) en divisant la différence de fréquence entre la première et la seconde fréquences par la différence des première et seconde tensions de commande, mesurées respectivement à la première et la seconde fréquences.

5. Synthétiseur selon la revendication 4, caractérisé en ce que lesdits moyens (13) de détermination comprennent en outre un convertisseur analogique-numérique (17) adapté pour convertir une tension mesurée par les moyens (15) de mesure en un signal numérique et en ce que ladite unité de calcul (19) est une unité numérique.

6. Synthétiseur selon l'une des revendications 1 à 3, caractérisé en ce que lesdits moyens (13) de détermination comprennent un capteur de température et une mémoire d'une table du gain de l'oscillateur commandé en tension en fonction de la température et une unité de commande pour délivrer le gain réel de l'oscillateur commandé en tension en fonction de la température mesurée et des valeurs de gain stockées dans la mémoire.

7. Synthétiseur selon l'une des revendications 1 à 3, caractérisé en ce que lesdits moyens (13) de détermination comprennent un moyen de mesure du temps de fonctionnement de l'oscillateur commandé en tension et une mémoire d'une table du gain de l'oscillateur commandé en tension en fonction de son temps de fonctionnement, et une unité de commande pour délivrer le gain réel de l'oscillateur commandé en tension en fonction du temps de fonctionnement délivré du compteur et des valeurs de gain stockées dans la mémoire.

8. Synthétiseur selon l'une des revendications 1 à 7, caractérisé en ce que les moyens (50) de compensation comprennent un multiplicateur (52) du signal de modulation par $2\pi$, un accumulateur (54) dont l'entrée est connectée à la sortie du multiplicateur (52), une unité (56) pour former d'une part un signal en phase I et d'autre part sa quadrature Q, un premier mélangeur (62) et un second mélangeur (64) disposés chacun dans une branche de la boucle de retour (9) en amont du compteur diviseur (8), le premier mélangeur (62) étant adapté pour mélanger le signal en phase I avec le signal en sortie de l'oscillateur commandé en tension (1) et le second mélangeur (64) étant adapté pour mélanger le signal en quadrature Q avec le signal en sortie de l'oscillateur commandé en tension (1) déphasé de $\pi/2$.

FIG_1

EP 1 079 514 A1

FIG_2

EP 1 079 514 A1

**Office européen des brevets**

# RAPPORT DE RECHERCHE EUROPEENNE

Numéro de la demande

EP 00 40 2323

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | WO 81 03250 A (GEN ELECTRIC ;TUGCU M (DK); SORENSEN S (DK)) 12 novembre 1981 (1981-11-12) * page 5, ligne 24 - page 7, ligne 24 * * page 10, ligne 17 - page 12, ligne 17; figure 2 * | 1 | H03C3/09 |
| Y | | 2-6,8 | |
| Y | US 4 309 674 A (OWEN DAVID P) 5 janvier 1982 (1982-01-05) * colonne 1, ligne 51 - colonne 3, ligne 34; figure 1 * | 2-5 | |
| Y | US 5 839 059 A (HAEKKINEN HANNU ET AL) 17 novembre 1998 (1998-11-17) * colonne 2, ligne 33 - colonne 5, ligne 14 * * revendications 1,4,5; figures 2,3 * | 6 | |
| Y | US 4 706 047 A (AVILA LOUIS J ET AL) 10 novembre 1987 (1987-11-10) * colonne 1, ligne 64 - colonne 2, ligne 55 * * colonne 4, ligne 37 - colonne 5, ligne 12; figures 1,4 * | 8 | DOMAINES TECHNIQUES RECHERCHES (Int.Cl.7) H03C H03L |
| A | US 5 097 230 A (LAUTZENHISER LLOYD L) 17 mars 1992 (1992-03-17) * colonne 20, ligne 25 - colonne 22, ligne 29; figures 13-14C,16 * | 8 | |

Le présent rapport a été établi pour toutes les revendications

| Lieu de la recherche | Date d'achèvement de la recherche | Examinateur |
|---|---|---|
| LA HAYE | 15 novembre 2000 | Balbinot, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

EP 1 079 514 A1

## ANNEXE AU RAPPORT DE RECHERCHE EUROPEENNE
## RELATIF A LA DEMANDE DE BREVET EUROPEEN NO.

EP 00 40 2323

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-11-2000

| Document brevet cité au rapport de recherche | | Date de publication | Membre(s) de la famille de brevet(s) | | Date de publication |
|---|---|---|---|---|---|
| WO 8103250 | A | 12-11-1981 | CA | 1175922 A | 09-10-1984 |
| | | | DE | 50124 T | 05-01-1983 |
| | | | DK | 578981 A | 28-12-1981 |
| | | | EP | 0050124 A | 28-04-1982 |
| US 4309674 | A | 05-01-1982 | GB | 2031676 A,B | 23-04-1980 |
| | | | DE | 2935582 A | 06-03-1980 |
| US 5839059 | A | 17-11-1998 | FI | 932204 A | 15-11-1994 |
| | | | AU | 6651994 A | 12-12-1994 |
| | | | DE | 69418192 D | 02-06-1999 |
| | | | DE | 69418192 T | 14-10-1999 |
| | | | EP | 0698313 A | 28-02-1996 |
| | | | WO | 9427372 A | 24-11-1994 |
| US 4706047 | A | 10-11-1987 | AUCUN | | |
| US 5097230 | A | 17-03-1992 | US | 5091706 A | 25-02-1992 |
| | | | CA | 2033878 A,C | 25-11-1991 |
| | | | CA | 2080013 C | 13-06-1995 |
| | | | EP | 0531451 A | 17-03-1993 |
| | | | WO | 9118444 A | 28-11-1991 |
| | | | US | 5802462 A | 01-09-1998 |
| | | | US | 5497509 A | 05-03-1996 |
| | | | US | 5311152 A | 10-05-1994 |
| | | | CA | 2033861 A,C | 25-11-1991 |

EPO FORM P0460

Pour tout renseignement concernant cette annexe : voir Journal Officiel de l'Office européen des brevets, No.12/82

11